# EUROPÄISCHE PATENTANMELDUNG

(11) **EP 1 698 715 A1**
(43) Veröffentlichungstag der Anmeldung: **06.09.2006**
(21) Anmeldenummer: 05021176.2
(22) Anmeldetag: 28.09.2005
(51) Int. Cl.: C23C 14/56, C03C 17/00

(54) **Anlage zum Beschichten eines Substrats und Einschubelement**

(30) Priorität: 03.03.2005 EP 05004725
(71) Anmelder: Applied Films GmbH & Co. KG, 63755 Alzenau (DE)
(72) Erfinder: Schuhmacher, Manfred, 63755 Alzenau (DE); Joos, Gerhard, 63785 Obernburg (DE)
(74) Vertreter: GROSSE BOCKHORNI SCHUMACHER

(57) **Zusammenfassung**

Eine Anlage 1 zum Beschichten eines Substrats 3, insbesondere eines transparenten Substrats, umfasst wenigstens eine Beschichtungskammer 2, wenigstens eine Pumpeinrichtung 5 zur Erzeugung eines Vakuums in der Beschichtungskammer 2, und wenigstens eine Sputterkathode 9. Eine oder mehrere Kathoden 9 sind mit Anlagenkomponenten, die prozessbedingt verschmutzen, beispielsweise Blenden, Abdeckungen oder Transportrollen 6 zum Transport eines Substrats 3 durch die Prozesskammer 2, in einem Einschub 8 integriert. Der Einschub 8 ist durch eine seitliche Öffnung 10 in der Kammerwand 2a in den Innenraum der Kammer schubladenartig einschiebbar. Alle wartungs- und reinigungsintensiven Komponenten der Beschichtungsanlage 1 können problemlos mit dem Einschub 8 zu Wartungszwecken aus dem Innenraum der Beschichtungskammer 2 herausgenommen werden. Der entfernte Einschub 8 kann unmittelbar durch einen frisch gewarteten Einschub ersetzt werden.

## Beschreibung

Die Erfindung betrifft eine Anlage zum Beschichten eines Substrats, insbesondere eines transparenten Substrats, insbesondere zur Herstellung von Architekturglas, umfassend wenigstens eine Beschichtungskammer, sowie ein Einschubelement für eine Anlage zum Beschichten eines Substrats, insbesondere eines transparenten Substrats.

Glasbeschichtungsanlagen zum Beschichten großflächiger Substrate, etwa großflächiger Architekturglasscheiben, arbeiten nach dem diskontinuierlichen Einschleusen der Substrate in der Regel kontinuierlich. Die Substrate werden durch eine Vielzahl von Kammern oder Kammersegmente, die hintereinander angeordnet sind, durchgeführt, wobei in den einzelnen Kammern gleiche oder unterschiedliche Behandlungs- und Beschichtungsprozesse ablaufen können. Zwischen benachbarten Beschichtungskammern können Pumpkammern angeordnet sein, die eine Kontamination zwischen den Kammern verhindern.

Die für den Prozess notwendigen Einbauten, wie Kathoden, Anoden, Blenden, Abschirmungen, Gaszuführungen, Kühleinrichtungen, u. ä. sind bei diesen Anlagen an Flanschen, Deckeln oder direkt an den Wänden im Innenraum der Beschichtungskammern befestigt. Insbesondere sind auch Transportrollen, die für den kontinuierlichen Transport des Substrats durch die Beschichtungskammer vorgesehen sind, fest im Gehäuse der Kammer eingebaut. Zur Wartung der Kathoden, für einen Targetwechsel oder für die Reinigung verschmutzter Komponenten wird die Beschichtungskammer durch Abnehmen eines oben auf einer Kammeröffnung aufliegenden Deckels zugänglich gemacht. Der Zugriff auf den Innenraum der Kammer ist jedoch unkomfortabel und mit hohem Aufwand verbunden. Die Anordnung der im Innenraum der Beschichtungskammer befestigten Komponenten ist für Wartungsarbeiten ungünstig. Unter Umständen müssen die Bauteile für die Wartungsarbeiten ausgebaut werden. Dadurch entstehen lange Betriebsausfallzeiten.

Bei den bekannten kontinuierlichen Beschichtungsanlagen, insbesondere bei Anlagen für großflächige Substrate, hat es sich außerdem bewährt, die Pumpeinrichtungen benachbart zu den Beschichtungskammern an der Oberseite und/oder Unterseite der Pumpkammern anzuordnen. Die Pumpeinrichtung ist dabei mit dem abnehmbaren Deckel verbunden, so dass wegen des zusätzlichen Gewichts zum Abnehmen des Deckels meist ein Kran eingesetzt werden muss.

Neben dem Problem des unkomfortablen Zugriffs zu den in der Beschichtungskammer oder an Flanschen befestigten Komponenten ergeben sich Probleme bei der Abdichtung der Öffnung beim Verschließen nach Beendigung der Wartungsarbeiten. Dies liegt daran, dass sich Verunreinigungen auf den Dichtflächen (die waagrecht angeordnet und dem Wartungspersonal zugänglich sind) leicht niederschlagen können. Aus diesem Grund werden die Dichtflächen nach einer Entfernung des Deckels vom Wartungspersonal sofort abgeklebt oder durch einen Rahmen abgedeckt.

Insgesamt ist die Handhabung der Anlage bei einer wartungsbedingten Betriebsunterbrechung zeitraubend und umständlich. Die durch den Beschichtungsprozess verschmutzte Umgebung der Kathode ist schwer zugänglich. Während die Kathode entnommen werden kann, muss die Reinigung der Kathodenumgebung im Innenraum der Kammer durchgeführt werden. Insbesondere können auch die im Gehäuse festgelegten Transportrollen für den Transport des Substrats nur mit großem Aufwand gesäubert werden. Die herabgefallenen Partikel können nur mit Schwierigkeiten aus der Kammer beseitigt werden.

Davon ausgehend ist es die Aufgabe der vorliegenden Erfindung, eine Beschichtungsanlage bzw. Komponenten einer Beschichtungsanlage so bereit zu stellen, dass Wartung, Reinigung und Targetwechsel vereinfacht und in kürzerer Zeit durchgeführt werden können.

Diese Aufgabe wird gelöst durch die Bereitstellung einer Anlage zum Beschichten eines Substrats gemäß Anspruch 1 und durch ein Einschubelement gemäß Anspruch 12.

Die Anlage zum Beschichten eines Substrats, insbesondere eines transparenten Substrats, insbesondere zur Herstellung von Architekturglas, umfasst wenigstens eine Beschichtungskammer, und wenigstens ein Einschubelement, das Beschichtungswerkzeuge zum Aufbringen einer Beschichtung auf das Substrat aufweist, die am Einschubelement angeordnet und zusammen mit dem Einschubelement in den Innenraum der Beschichtungskammer einschiebbar bzw. aus diesem herausziehbar sind.

Das bzw. die Einschubelemente der Anlage können alle im Folgenden dargestellten Eigenschaften und Merkmale, insbesondere auch die im Zusammenhang mit dem Einschubelement beanspruchten Merkmale, aufweisen.

Durch den Einsatz mehrerer Einschubelemente in einer Anlage wird ein modulartiges System geschaffen, bei dem komplette Kathodenstationen mit einer fertig bestückten Einheit auf einfache Art ausgetauscht werden können. Targetwechsel können so schneller durchgeführt werden. Dies erweist sich als besonders günstig, da die Zeitabstände, in denen ein Targetwechsel vorgenommen werden muss, von Target zu Target unterschiedlich sein können. In der Praxis ist prinzipiell genug Arbeitsraum vorhanden, wenn jeder zweite Einschub herausgezogen ist, so dass an den herausgezogenen Einschüben gleichzeitig gearbeitet werden kann. Es kann jedoch auch an allen Einschubelementen gleichzeitig gearbeitet werden, wenn jeder zweite Einschub weiter entfernt von der Anlage an einem Bearbeitungsplatz abgestellt wird. Prinzipiell ist auch eine Anordnung von Einschubelementen an beiden Seiten der Kammer möglich.

Insbesondere ist wenigstens eine Öffnung an einer Seitenwand der Beschichtungskammer derart ausgebildet, dass das Einschubelement in die Beschichtungskammer einschiebbar ist. Durch den seitlichen Zugriff auf das Einschubelement und die mit ihm verbundenen Komponenten werden die Nachteile beim Zugriff von oben vermieden. Bei der Abdichtung der Öffnungen herkömmlicher Beschichtungskammern, die von einem aufliegenden Flansch verschlossen werden, treten durch die Verschmutzung der waagrechten Dichtflächen Probleme auf. Ein Abkleben oder Abdecken der Dichtflächen unmittelbar nach dem Öffnen ist notwendig. Beim seitlichen Eingriff ist die Gefahr von Verschmutzungen verringert, da die Dichtflächen nicht horizontal angeordnet sind und der Zugriff auf die zu wartenden Komponenten nicht in der Nähe dieser Dichtflächen erfolgt. Die Dichtungsbereiche an den seitlichen Einschuböffnungen sind zudem kürzer als die Dichtungsbereiche an der Öffnung im Deckelbereich.

Die Beschichtungskammer und das Einschubelement sind bevorzugt derart aneinander angepasst, dass das Einschubelement schubladenartig in die Öffnung der Beschichtungskammer einschiebbar ist.

Die Anlage wird wenigstens eine Pumpeinrichtung zur Erzeugung eines Vakuums in der Beschichtungskammer aufweisen. Die Pumpeinrichtung ist an der Oberseite und/oder an der Unterseite des Kammergehäuses angeordnet. Besonders günstig für einen bequemen Zugriff ist eine Anordnung seitlich an einem sich nach oben und/oder nach unten von der Beschichtungskammer erstreckenden Pumpenkasten. Diese Anordnung wird jedoch erst durch die Kernidee der Erfindung, die Bereitstellung des Einschubelements, ermöglicht, da sie eine höhere Flexibilität bei der Anordnung der Pumpen mit sich bringt. Die Länge der gesamten Anlage kann verringert werden, da durch die beschriebene günstige Anordnung der Pumpen auf Pumpkammern zwischen den Beschichtungsstationen verzichtet werden kann.

Das Einschubelement wird in der Regel unabhängig von der Pumpeinrichtung gegenüber der Beschichtungskammer bewegbar angeordnet sein. Während die Pumpeinrichtung an der Kammer befestigt ist, kann das Einschubelement mit den darin integrierten Komponenten verfahren werden. Es müssen keine Deckel und Pumpen bewegt werden, um an die am Einschub befestigten Funktionsteile zu gelangen.

Die Anlage ist insbesondere so ausgebildet, dass ein flächiges Substrat im Wesentlichen horizontal durch die Beschichtungskammer transportiert wird. Allerdings soll auch eine vertikale Führung des Substrats im Rahmen der Erfindung liegen.

Entsprechend sind bevorzugt die im Einschubelement integrierten Kathoden horizontal ausgerichtet.

Das Einschubelement umfasst in einer bevorzugten Ausführungsform einen Anschluss für die Spannungsversorgung des Einschubelements, der so ausgebildet ist, dass er beim Einschub des Einschubelements in die Beschichtungskammer mit einem an der Anlage angeordneten entsprechenden Anschluss in Eingriff kommt, um die Versorgungsverbindung herzustellen. Beim Herausziehen des Einschubelements aus der Kammer löst sich der Kontakt automatisch, so dass die Verbindung nicht manuell vom Personal getrennt werden muss.

Die Beschichtungskammer weist insbesondere in ihrem Innenraum eine oder mehrere Kupplungen auf, um mit den am Einschubelement befestigten Transportrollen zu koppeln. Im Wesentlichen verbleiben in der Kammer nur noch die Sensoren zur Prozessüberwachung und die Kupplungen für die Transportrollen. Die Beschichtungskammer ist nur noch mit den Komponenten ausgestattet, auf die nicht regelmäßig zugegriffen werden muss. Die Kammer selbst ist ein einfaches Stahlplattengehäuse mit Laufschienen für die Einschubelemente und der Transportrollenkupplung.

Die Anlage kann ein Gasregelmodul aufweisen, das mit der Beschichtungskammer verbunden ist, wobei das Gasregelmodul wenigstens einen Gasanschluss zum Kammerinneren aufweist, und das Einschubelement entsprechende Gasanschlüsse und Gasleitungen aufweist, durch die vom Gasregelmodul zugeführtes Prozessgas durch den Innenraum der Kammer geleitet und über die das Prozessgas in die Kammer eingebracht werden kann.

Das erfindungsgemäße Einschubelement für eine Anlage zum Beschichten eines Substrats, insbesondere eines transparenten Substrats, weist Beschichtungswerkzeuge zum Aufbringen einer Beschichtung auf das Substrat auf, die am Einschubelement angeordnet und zusammen mit dem Einschubelement in den Innenraum einer Beschichtungskammer einschiebbar bzw. aus diesem herausziehbar sind.

Unter Beschichtungswerkzeuge sollen hier insbesondere Sputterquellen, Sputterkathoden, Magnetrons usw. verstanden werden. Allerdings soll die Erfindung auch Werkzeuge im Zusammenhang mit anderen Beschichtungsverfahren, beispielsweise das Aufdampfen einer Beschichtung, oder die Verwendung einer Ionenquelle zur Vor-/Nachbehandlung des Substrats umfassen.

Dadurch, dass eine in die Kammer einschiebbare bzw. aus dieser herausziehbare selbstständige Einheit vorgesehen ist, an der die Beschichtungswerkzeuge befestigt sind, wird die Zugänglichkeit zu diesen Komponenten wesentlich erleichtert. Zum einen müssen keine Deckel oder Flansche abgehoben werden. Zum anderen stehen die Beschichtungswerkzeuge unmittelbar nach dem Herausziehen der Einheit aus der Beschichtungskammer für die Wartung zur Verfügung. Ein zusätzlicher teuerer Kathodentransportwagen, der auch für die weitere Bearbeitung eine Einrichtung zum Umschwenken der Kathode umfasst, kann dadurch eingespart werden. Es ist nicht notwendig, auf den Innenraum der Kammer zuzugreifen, etwa um die Beschichtungswerkzeuge auszubauen. Zudem ist ein schneller und unkomplizierter Austausch einer zu wartenden Einheit gegen einen vorbereiteten Ersatzeinschub möglich. Die Reinigung und Wartung kann ohne Zeitdruck vorgenommen werden, da während der Durchführung der Arbeiten die Anlage mit dem Ersatzeinschub in Betrieb gehen kann. Auf diese Weise wird die Wartung vereinfacht. Ausfallzeiten der Anlage können deutlich reduziert werden.

Das Einschubelement kann beim Einschieben in die bzw. beim Herausziehen aus der Beschichtungskammer mittels eines Hubwagens, auf Rollen, auf einem Luftpolster, auf Schienen, o. ä. bewegt werden.

Insbesondere ist das Einschubelement schubladenartig in den Innenraum der Beschichtungskammer einschiebbar bzw. aus diesem herausziehbar.

Im Einschubelement sind bevorzugt weitere Komponenten einer Beschichtungsanlage integriert, die einem prozessbedingten Verschleiß, einer prozessbedingten Verschmutzung und/oder einer Beaufschlagung mit Beschichtungsmaterial unterliegen. Alle diese Komponenten sind somit leicht zugänglich.

Einer prozessbedingten Verschmutzung unterliegen insbesondere die Bauteile, die in der Umgebung der Kathode angeordnet sind und während des Beschichtungsprozesses unmittelbar oder mittelbar von Beschichtungsteilchen oder Verunreinigungen getroffen werden. Blenden, Abschirmungen, Kathodengegenwände und Anoden sind davon besonders betroffen. Diese Komponenten müssen regelmäßig gereinigt, beispielsweise sandgestrahlt werden. Selbstverständlich sollten möglichst alle Komponenten, die einer prozessbedingten Verschmutzung, d.h. einem direkten Auftreffen von Beschichtungsmaterial (oder dem Auftreffen gestreuter Teilchen) unterliegen, im Einschubelement integriert sein. Auf diese Weise kann auf jeden (wartungsbedingten) Zugriff in den Innenraum der Kammer verzichtet werden. Mit dem Einschubelement werden alle Komponenten der Anlage herausgezogen, auf die im Rahmen der Wartung zugegriffen werden können soll. Ähnliches gilt für Verschleißteile, insbesondere für die Sputterkathoden.

Das Einschubelement wird auch Blenden und/oder Abschirmungen aufweisen. Das Einschubelement kann so aufgebaut sein, dass an geeigneten Stellen Abschirmungen angebracht werden, um eine Verschmutzung des Innenraums der Beschichtungskammer oder anderer Komponenten zu verhindern. Auf diese Weise gelangt jedenfalls kein Beschichtungsmaterial unkontrolliert in den Raum außerhalb des Einschubelements.

Das Beschichtungswerkzeug kann wenigstens eine Kathode umfassen. Dies kann wenigstens eine Flachkathode oder wenigstens eine rotierbare Kathode sein.

Das Beschichtungswerkzeug kann wenigstens eine Kathode umfassen. Dies kann wenigstens eine Flachkathode oder wenigstens eine rotierbare Kathode sein. Es gibt verschiedene Möglichkeiten, rotierbare Kathoden in das Einschubelement zu integrieren. Bei der bevorzugten Ausführungsform wird das Rohrtarget einer rotierbaren Kathode an einer Vakuumdrehdurchführung befestigt, die parallel zur Drehachse des Rohrtargets im stirnseitigen Flansch des Einschubelementes angeordnet ist. Am gegenüberliegenden Ende des Einschubelements wird das Rohrtarget in einer Halterung drehbar gelagert, die im Bereich der Verlängerung der Drehachse angeordnet ist.

Bei einer weiteren Ausführungsform greift man auf kommerziell erhältliche komplette Rohrkathoden zurück. Hier umfasst das Beschichtungswerkzeug wenigstens zwei Halterungen zum Halten der Kathode. Die Halterungsblöcke bilden zusammen mit dem Target, das insbesondere ein Rohrtarget sein kann, mit der Medienzuführung und dem Kathodenantrieb eine Kathodeneinheit. Die Kathode ist an den beiden Halterungsblöcken drehbar befestigt.

Bei herkömmlichen Anlagen werden die Kathodeneinheiten an einem Deckel an der Vakuumanlage hängend in diese eingebaut. Die Kathodeneinheit, die als Magnetron ausgeführt ist, weist eine Magnetanordnung auf, die im Inneren der Rohrkathode angeordnet ist. Die beispielsweise als Magnetleiste ausgebildete Magnetanordnung muss für den Betrieb in Sputterrichtung, d.h. zum Substrat hin, ausgerichtet sein.

Bei der vorliegenden Erfindung dagegen werden die Halterungsblöcke vorzugsweise stehend an dem erfindungsgemäßen Einschubelement befestigt. Im Beschichtungsbetrieb bewegen sich die Substrate zwischen den beiden Halterungsblöcken unter dem Kathodenrohr hindurch. Die Kathodeneinheit zusammen mit der Magnetanordnung wird somit, anders als beim herkömmlichen Aufbau, bei der Montage im Einschubelement so eingebaut, dass die Magnetleiste nicht zum Substrat weist, sondern genau entgegengesetzt zur Kammerdecke weist. Es muss also nur die Magnetleiste für den Einbau der Kathodeneinheit im Einschubelement um 180° gedreht werden, was aufgrund der symmetrisch ausgeführten Befestigungselemente im Inneren des Rohrtargets ohne weiteres möglich ist. Zum Wechsel des Rohrtargets kann das Einschubelement aus der Beschichtungskammer herausgezogen und das Target vom Einschubelement abgenommen werden, ohne dass nach Abtrennen der Medienversorgung (Kühlwasser, Elektrizität) die gesamte Einheit, bestehend aus Kammerdeckel, Halterungsblöcken und Kathode, bewegt werden muss.. Während also bei herkömmlichen Anlagen zum Austausch (Targeteinbau und Targetausbau) verbrauchter Targets nach Entfernen der Anschlussleitungen der Deckel angehoben, an einer speziellen Vorrichtung befestigt und um 180° gedreht werden muss, kann die erfindungsgemäße Kathodeneinheit mit Magnetsystem auf den Halterungsblöcken stehend im Einschubelement befestigt bleiben und das Target nach Lösen der entsprechenden Befestigung entnommen werden. Auf diese Weise können sowohl die Wartungszeiten als auch die Unfallgefährdung beim Targetwechsel verringert werden. Ferner kann auf eine Vorrichtung zum Wenden der Kathoden verzichtet werden.

Außerdem können die Medienanschlüsse bei der Anordnung durch die Halterungsblöcke auf der Seite unterhalb des zu beschichtenden Substrats angeordnet sein, d.h. die Medienleitungen werden von der Kathode nach unten in Richtung unterhalb des Substrats geführt.

Das Einschubelement kann eine Vorrichtung zum Drehen der Kathode, insbesondere im Fall einer Flachkathode, in eine Position zum Zugriff für Wartungszwecke und/oder für einen Kathodenwechsel aufweisen. Dies kann beispielsweise eine Kurbel oder ein Hebel sein, mit der die im "Sputter-Down"-Verfahren betriebene Flachkathode nach dem Herausziehen des Einschubelements aus der Beschichtungskammer um ca. 180° gedreht werden kann, so dass sie nach oben gerichtet ist. Auf diese Weise erhält das Wartungspersonal bequemen Zugriff auf die Verschraubung der Kathode und kann das Target ohne Aufwand austauschen.

Das Einschubelement kann zudem eine Antriebseinheit oder eine Kupplung für eine Antriebseinheit zur Rotation einer Drehkathode aufweisen. Der Antrieb kann in einem Teil des Einschubelements angeordnet werden, der sich außerhalb der Kammer befindet. Auch kann der Antrieb an der der Einschuböffnung gegenüber liegenden Seite außerhalb der Kammer befestigt sein und über Kupplungen die drehbaren Kathoden bei geschlossener Anlage antreiben.

Außerdem ist es denkbar, mit einem Einschubelement an der Vorderseite der Anlage nur die Kathoden zugänglich zu machen, und in einem weiteren Einschubelement an der Rückseite nur die Kathodenumgebung oder die Transportrollen anzuordnen. Auch sind beidseitig mehrere getrennt bedienbare Einzeleinschubelemente möglich. Dies könnte durch zwei oder mehrere ineinander greifende einzelne Einschubelemente realisiert werden. Die einzelnen Komponenten der Beschichtungsanlage, insbesondere die dem prozessbedingten Verschleiß oder der prozessbedingten Verschmutzung ausgesetzten Komponenten, können auf den getrennten Einschubelementen in geeigneter Weise angeordnet werden. Nicht nur die beanspruchten Einschubelemente an sich sollen ein Teil der Erfindung sein, sondern auch die Kombinationen dieser Einschubelemente mit den weiteren Einschubelementen, die zwar keine Kathoden aufweisen, jedoch andere Beschichtungskomponenten tragen.

Das Einschubelement kann wenigstens eine Anode aufweisen. Die Anode sollte jedenfalls dann ein Teil des Einschubelements sein, wenn sie der Verschmutzung durch Beschichtungsmaterial unterliegt.

Das Einschubelement weist bevorzugt eine Transporteinrichtung zum vorzugsweise kontinuierlichen Transport des Substrats auf.

Die Transporteinrichtung umfasst insbesondere Transportrollen, durch die das Substrat bewegt wird. Der Antrieb für die Transportrollen kann innerhalb oder außerhalb der Beschichtungskammer angeordnet sein und die Transportrollen über eine Kupplung antreiben. Die Transportrollen können durch Schutzbleche abgeschirmt sein, die ebenfalls Teil des Einschubelements sind.

Das Einschubelement kann zudem eine Vorrichtung zur Kühlung der Blenden, Abschirmungen und/oder der Beschichtungswerkzeuge aufweisen. Das Einschubelement wird mit einem Kühlmedium versorgt, welches über Leitungen zu den entsprechenden zu kühlenden Komponenten geführt wird.

Das Einschubelement weist bevorzugt einen Flansch zum Verschluss einer für den Einschub des Einschubelements vorgesehenen Öffnung in der Beschichtungskammer auf.

Insbesondere ist das Einschubelement verfahrbar oder verschiebbar ausgebildet. Dazu können beispielsweise Rollen, ein Luftpolster, usw. vorgesehen sein. Es können auch Hilfsmittel verwendet werden, z.B. ein Hubwagen, der unter das Einschubelement eingreifen und dieses anheben kann, oder Schienen, auf denen das Einschubelement bewegt werden kann.

Das Einschubelement kann Versorgungseinrichtungen für die Medienversorgung aufweisen. Dies sind insbesondere Leitungen für die Versorgung der Kammer mit Gas und/oder mit Kühlwasser für Blenden und/oder für die Kathoden und/oder mit elektrischer Spannung.

Die Gasversorgung ist zum Zudosieren von Prozessgas vorgesehen. Das Einschubelement kann insbesondere auch Regler für die Regelung der Gaszufuhr aufweisen. Die Regelung kann dabei so erfolgen, dass die Zufuhr über die gesamte Breite der Beschichtungskammer einheitlich oder abschnittsweise durchgeführt wird. Beispielsweise kann eine mehrfach geteilte Gasleitung verwendet werden, um den Zufluss an Prozessgas gezielt an einer bestimmten Stelle in der Kammer zu regeln. Die Anordnung der Gasflussregler nahe dem Einschubelement hat den Vorteil, dass der Gasfluss auf Grund der kurzen Strecke zu den Austrittsöffnungen in der Kammer schnell und flexibel geändert werden kann.

In einer bevorzugten Ausführungsform werden die Gasflussregler an der Beschichtungskammer nahe der Trennstelle zum Einschubelement befestigt und somit einer bestimmten Prozesskammer zugeordnet. Dadurch kann das Einschubelement kostengünstiger gestaltet werden. Die Trennung der Gasverbindung wird in die Vakuumkammer verlegt, so dass eventuelle Undichtigkeiten an der Trennstelle der Gasleitung nicht nach außen hin wirksam werden können. Die Gasleitung ist nach dem Gasflussregler fast drucklos, nämlich an den Prozesskammerdruck angepasst, wogegen die Gaszuführungsleitungen von der Gasversorgung bis zum Gasflussregler einen Druck von ca. 3 bar aufweisen. Die Trennung erfolgt also problemloser im drucklosen Teil der Gasleitungen, und bei eventuellen Undichtigkeiten tritt das Gas in die Prozesskammer hin aus, wo es ohnehin gewünscht wird.

Das Einschubelement kann außerdem Anschlüsse für die Medienversorgung aufweisen. An einem Abschnitt des Einschubelements, der sich stets außerhalb der Beschichtungskammer befindet, sind Versorgungs- und/oder Entsorgungsanschlüsse für die Versorgung mit Gas und/oder Kühlwasser für Blenden und/oder Kathoden und/oder für elektrische Spannung vorgesehen.

Das Einschubelement kann bevorzugt derart ausgebildet sein, dass beidseitig des Transportwegs des Substrats Beschichtungswerkzeuge zur beidseitigen Beschichtung des Substrats angeordnet sind. Die Kathoden und die Abschirmungen sind in diesem Fall im Wesentlichen symmetrisch bezüglich des flächigen Substrats angeordnet. Es findet eine gleichzeitige Beschichtung beider Seiten des Substrats statt.

Insbesondere können die Transportrollen derart angeordnet sein, dass die den Rollen zugewandte Seite eines Substrats durch rollenseitig angeordnete Beschichtungswerkzeuge beschichtet werden kann. Eine Beschichtung in diesem sogenannten "Sputter-up"-Verfahren erfordert eine spezielle Anordnung der Rollen. Der Abstand zwischen den in Transportrichtung aufeinander folgenden Antriebsachsen, welche die Transportrollen bewegen, muss ausreichend groß sein, so dass genügend von den unterhalb des Substrats angeordneten Targets abgesputtertes Material auf das Substrat auftreffen kann. Gleichzeitig muss der Abstand so eingestellt werden, dass ein zuverlässiger Transport des Substrats unter Verhinderung eines Durchbiegens des Substrats gewährleistet ist.

Die Transportrollen können ferner eine Abschirmung derart aufweisen, dass die Verschmutzung der Rollen durch unmittelbar von den Beschichtungswerkzeugen abgesputtertes Material verhindert wird. Ungeschützte Rollen würden wie das Substrat beschichtet werden. Diese Beschichtung stellt jedoch eine Verschmutzung der Rollen dar, die dazu führt, dass die Oberfläche des Substrats beim Kontakt mit den Rollen zusätzlich belastet und unter Umständen beschädigt wird.

Diese Abschirmungen für die Transportrollen beidseitig einer Durchtrittsöffnung für das Schichtmaterial werden in vorteilhafter Weise ohne Unterbrechungen über die ganze Anlagenbreite ausgebildet. Wären die Abschirmungen unter Freilassen der Zwischenräume nur um jede Transportrolle herum angeordnet, würden sie das von der Kathode abgestäubte Beschichtungsmaterial herausfangen, das in diesen Bereichen nicht auf das Substrat gelangen könnte. Die Folge wären sichtbare Streifen auf den Glassubstraten wegen einer, über die Substratbreite gesehen, stark schwankenden Schichtdicke.

Da regelmäßig kein Zugriff auf den Innenraum notwendig ist, können die Betriebszeiten der Anlage verlängert werden. Zudem werden die Arbeitsbedingungen für das Wartungspersonal verbessert, die Anlagenmontagezeit wird erheblich verkürzt und eine Beschichtung der Kammer wird verhindert.

Weitere Vorteile und Merkmale der vorliegenden Erfindung werden anhand der nachfolgenden Beschreibung eines bevorzugten Ausführungsbeispiels und der beigefügten Zeichnungen deutlich. Es zeigen:
- Fig. 1: eine Ansicht einer erfindungsgemäßen Beschichtungsanlage im Schnitt senkrecht zur Transportrichtung des Substrats;
- Fig. 2: eine weitere Schnittansicht einer Beschichtungsanlage längs der Transportrichtung des Substrats;
- Fig. 3: eine Schnittansicht zweier Kammersegmente mit erfindungsgemäßen Einschüben in einem Schnitt längs der Transportrichtung des Substrats;
- Fig. 4: eine Schnittansicht mehrerer Kammersegmente mit unterschiedlich ausgebildeten Einschüben in einem Schnitt längs der Transportrichtung des Substrats;
- Fig. 5: eine perspektivische Ansicht eines erfindungsgemäßen Einschubs;
- Fig. 6: eine weitere perspektivische Ansicht eines erfindungsgemäßen Einschubs;
- Fig. 7: eine schematische Darstellung eines Einschubwechsels;
- Fig. 8: eine Darstellung einer speziellen Ausführungsform eines Gasregelmoduls;
- Fig. 9: ein Detail der Fig. 8;
- Fig. 10a: eine in herkömmlicher Art an einem Flansch befestigte Kathodeneinheit;
- Fig. 10b: eine erfindungsgemäß an einem Einschubelement befestigte Kathodeneinheit;
- Fig. 11a: ein Beschichtungskompartment mit einer Kathodeneinheit gemäß Fig. 10b im Längsschnitt (bezüglich der Substrat-Transportrichtung);
- Fig. 11b: das Kompartment aus Fig. 11a im Querschnitt (bezüglich der SubstratTransportrichtung); und
- Fig. 12: eine Beschichtungskammer mit einem daneben positionierten erfindungsgemäßen Einschubelement.

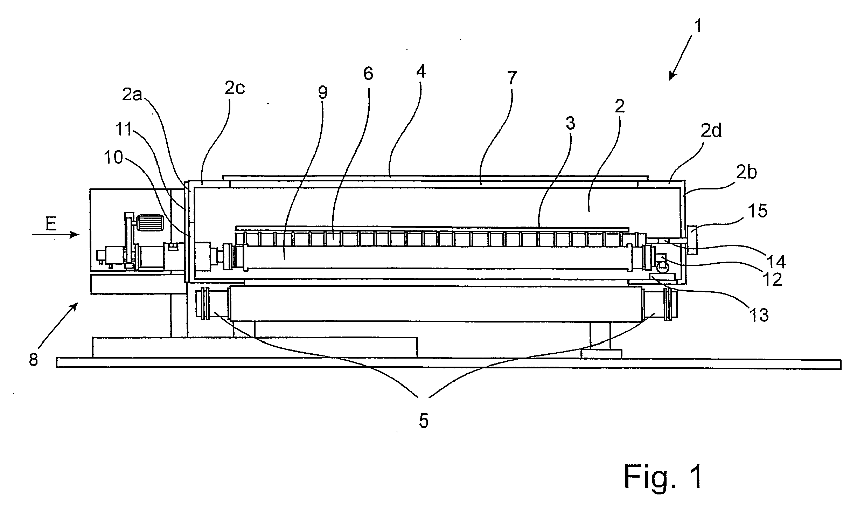

Fig. 1 zeigt eine Schnittansicht einer kontinuierlich arbeitenden Glasbeschichtungsanlage 1 mit einer Beschichtungskammer 2. Der Schnitt durch die Beschichtungsanlage 1 erstreckt sich senkrecht zur Transportrichtung eines Substrats 3. Das Substrat 3 wird in der skizzierten Anlage 1 von Rollen 6 horizontal liegend senkrecht zur Blattebene gefördert.

Die Beschichtungskammer 2 wird seitlich durch Seitenwände 2a, 2b begrenzt. Auf zwei Flanschen 2c, 2d, die sich von den Seitenwänden 2a bzw. 2b oben horizontal nach innen erstrecken, liegt ein Kammerdeckel 4 auf, der eine Öffnung 7 der Kammer 2 verschließt.

Bei herkömmlichen Anlagen sind die Pumpeinrichtungen in der Regel auf diesem Deckel angeordnet. Zugleich stellt die vom Deckel abgeschlossene Öffnung den einzigen Zugang zum Kammerinneren dar. Bei jeder Wartung muss somit aufwändig der Deckel entfernt werden, um Zugriff zu den in der Beschichtungskammer oder an Flanschen befestigten Komponenten zu erhalten. Der Zugang zum Kammerinneren, in dem die Komponenten angeordnet sind, ist jedoch unkomfortabel. Außerdem ergeben sich durch die Ausmaße der Öffnung und durch die waagrechte Positionierung der Dichtflächen Probleme bei der Abdichtung durch Verunreinigungen, die sich auf den Dichtflächen leicht niederschlagen können.

Wie aus der Fig. 1 deutlich wird, sind die Pumpen 5 (Turbomolekularpumpen TMP) bei der erfindungsgemäßen Anlage 1 im wesentlichen in den Seitenbereichen unterhalb der Beschichtungskammer 2 angeordnet. Diese Anordnung ist für die Wartung und den Zugriff auf die Pumpen 5 besonders günstig. Im Ausführungsbeispiel wird ein "Sputter-Up"-Verfahren verwendet. Dabei ist das Substrat 3 beim Transport und während des Beschichtungsprozesses horizontal angeordnet. Die Beschichtung erfolgt von unten nach oben, d.h. die Kathode 9 befindet sich unterhalb des Substrats 3. Beim "Sputter-Down"-Verfahren sind die Verhältnisse umgekehrt. Die Pumpen 5 können jedoch auch oberhalb der Kammer 2 angeordnet sein, ohne dass sich dadurch erhebliche Nachteile ergeben; auch eine Kombination beider Verfahren zum zweiseitigen Beschichten mit einer symmetrischen Anordnung der Pumpen 5 oberhalb und unterhalb der Kammer 2 wäre denkbar. Es hat sich gezeigt, dass es die beschriebene Anordnung der Pumpen 5 überflüssig macht, Pumpkammern zwischen jeweils zwei aufeinender folgenden Beschichtungskammern 2 vorzusehen. Dadurch kann die Anlagenkonstruktion baulich verkürzt werden.

Entscheidend für die vorliegende Erfindung ist jedoch die Bereitstellung eines Einschubs 8, so dass auf einen Zugriff in das Innere der Kammer 2 durch die Öffnung 7 für eine reguläre Wartung weitgehend verzichtet werden kann.

Der schubladenartige Einschub 8 ist eine Einheit verschiedener Bauteile, die in dem Einschub 8 zusammengefasst sind. Der Einschub 8 weist einen vertikal ausgerichteten, flachen Flansch 11 auf, der im Betriebszustand eine seitliche Öffnung 10 in der Wand 2a der Beschichtungskammer 2 verschließt.

Am Einschub 8 sind alle wartungsintensiven Bauteile befestigt, beispielsweise die Sputterkathoden 9, die regelmäßig ausgetauscht werden müssen, Transportrollen 6, die prozessbedingt verschmutzen, Blenden, Abschirmungen und alle weiteren dem Beschichtungsmaterial im Betrieb direkt oder indirekt ausgesetzten Bauteile. Mit dem Einschub 8 sind möglichst alle Abschirmungen und Schutzbleche verbunden, die ein Verschmutzen der Innenwände der Kammer 2, beispielsweise im Substrathintergrund (hier also oberhalb des Substrats 3), verhindern.

Außerdem kann die gesamte Medienversorgung, z. B. die Versorgung mit Prozessgas, mit Kühlwasser für Kathoden und Abschirmungen, mit elektrischer Spannung, usw. über Leitungen erfolgen, die mit dem Einschub 8 verbunden sind.

Der Einschub 8 wird in der Darstellung gemäß Fig. 1 von links nach rechts schubladenartig durch eine Öffnung 10 in der Seitenwand 2a in die Kammer 2 hinein geschoben (Einschubrichtung E), bis der Flansch 11 des Einschubs 8 an der Seitenwand 2a anliegt. Durch das Abpumpen der Kammer 2 wird eine Abdichtung zwischen dem Flansch 11 und der Seitenwand 2a hergestellt. Die Dichtbereiche sind im wesentlichen stets senkrecht positioniert, verschmutzen also nicht leicht, und sind im Vergleich zu den Dichtbereichen am Flansch 4 an der oberen Öffnung 7 kleiner, also einfacher zu säubern und zu handhaben.

Beim Einführen des Einschubs 8 in die Kammer 2, beispielsweise mittels eines Hubwagens, wirkt eine am Einschub 8 angeordnete Rolle 12 auf dem letzten Abschnitt der Wegstrecke vor Erreichen der Betriebsposition mit einer Führung 13 zusammen, um den Einschub 8 richtig zu justieren. Eine vergleichbare Führungskonstruktion kann auch im Bereich der Öffnung 10 vorgesehen sein, um das Einschieben und Herausnehmen des Einschubs 8 zu erleichtern. Alternativen, wie ein auf der letzten Wegstrecke eingreifender Führungsstift, sind ebenfalls denkbar.

Die mit dem Einschub 8 verbundenen Transportrollen 6 können mittels einer Kupplung 14 mit einem Antriebselement 15 verbunden und von diesem angetrieben werden. Die Kupplung 14 überträgt beispielsweise die Drehung eines außerhalb der Kammer 2 angeordneten Antriebsrads auf die Rollen 6. Der Transportrollenantrieb 15 kann auf unterschiedliche Art ausgeführt sein. So kann der Antrieb innerhalb oder außerhalb der Anlage angeordnet werden. Bei der Anordnung außerhalb der Kammer 2 wird die Antriebsachse mittels einer Vakuumdrehdurchführung durch die Kammerseitenwand 2b geführt. Die Kraftübertragung kann über Kegelräder, Riemenantriebe (Zahnriemen), Zahnräder o. ä. erfolgen.

Die Kupplung 14 kann eines der wenigen oder das einzige Einbauteil sein, das bei ausgezogenem Einschub 8 im Innenraum der Beschichtungskammer 2 verbleibt. Außerdem ist es sinnvoll, bestimmte Sensoren zur Prozesssteuerung in der Kammer 2 anzubringen, jedoch nur, soweit eine Verschmutzung der Sensoren mit Beschichtungsmaterial während des Prozesses nicht stattfindet.

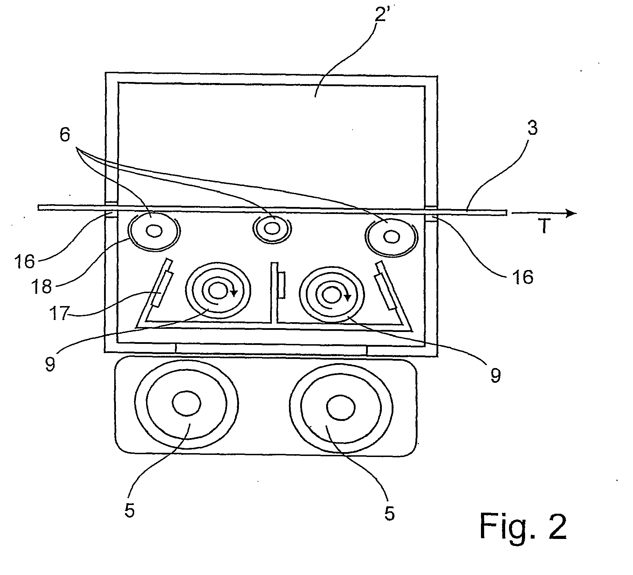

Fig. 2 zeigt eine vertikale Schnittansicht eines Kammersegments 2' mit einem Einschub 8 in einem Schnitt längs der Transportrichtung T des Substrats 3. Das Substrat 3 wird von den Transportrollen 6 über Schleusen 16 durch den Innenraum des Kammersegments 2' bewegt. Die Transporteinrichtung 6 für das Substrat 3 ist als Teil des Einschubs 8 mit diesem verbunden. Ferner umfasst der Einschub 8 in dieser Ausführungsform zwei rotierbare Kathoden 9, Blenden bzw. Anoden 17 und zusätzliche Abschirmungen 18 für die Transportrollen. Die genannten Komponenten können somit zu Wartungszwecken zusammen mit dem Einschub 8 aus dem Innenraum der Beschichtungskammer 2 herausgezogen werden.

Die Abschirmflächen (hier die Blenden 17) sind in dieser Ausführungsform als offenes Trapez ausgebildet und übernehmen auch die Funktion der Anoden. Im Raum hinter den Kathoden 9 können die im Betrieb waagrecht angeordneten Abschirmungen Unterbrechungen aufweisen, durch die hindurch im Kammerinnenraum vorhandenes Gas zu den Hochvakuumpumpen 5 gelangt.

Aus der Fig. 2 wird außerdem deutlich, dass das Substrat 3 mit Hilfe der unterhalb des Substrats 3 angeordneten Kathoden 9 von unten her beschichtet werden kann. Die Transportrollen 6 sind hinsichtlich des Substrats auf der gleichen Seite wie die Kathoden 9, nämlich unterhalb des Substrats 3, angeordnet. Um eine effektive Beschichtung des Substrats 3 in diesem sogenannten "Sputter-up"-Modus zu erreichen, muss ein Abstand zwischen den Transportrollen 6 in der Transportrichtung derart vorgesehen sein, dass ausreichend abgesputtertes Beschichtungsmaterial auf das Substrat 3 auftreffen kann, ohne den Substrattransport zu beeinträchtigen.

Die Transportrollen 6 müssen ferner durch eine Abschirmung 18 zumindest vor einem Auftreffen von direkt von den Kathoden 9 ankommenden Teilchen geschützt werden. Andernfalls würden die Transportrollen 6 selbst beschichtet werden und mit der Zeit so stark verschmutzen, dass eine Beschädigung des Substrats 3 bzw. der Beschichtung des Substrats 3 durch die Transportrollen 6 zu erwarten wäre.

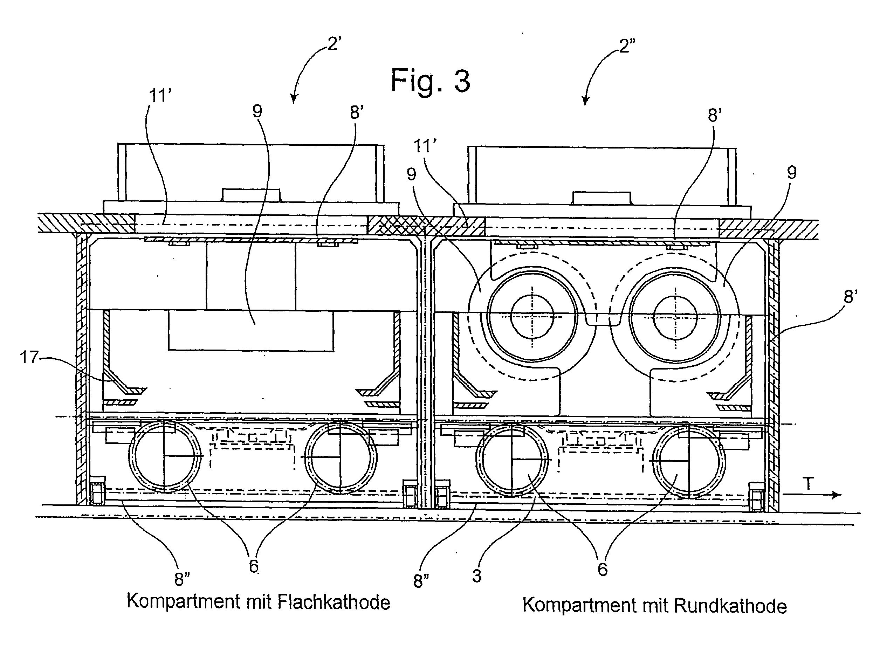

In der Fig. 3 sind zwei Kammersegmente 2', 2" mit jeweiligen Einschüben 8 in einer vertikalen Schnittansicht längs der Transportrichtung T des Substrats dargestellt. Die Segmente 2', 2" sind für das "Sputter-Down"-Verfahren vorgesehen. Ein Substrat 3 wird über jeweils zwei Transportrollen 6 durch die Kammersegmente 2', 2" geführt.

Der erste Einschub 8 (links dargestellt) weist eine Flachkathode 9 auf, der zweite Einschub 8 (rechts dargestellt) zwei rotierbare Rundkathoden 9. Bei den Sputterkathoden 9 kann es sich im Allgemeinen auch um Magnetrons handeln. Zudem wäre es denkbar, den Kemgedanken der Erfindung auf andere Beschichtungsverfahren, z.B. ein Aufdampfen (PVD, CVD), zu übertragen. Die für den jeweiligen Prozess benötigten Beschichtungswerkzeuge werden in jedem Fall im Einschub 8 integriert, um einen unkomplizierten Austausch und Wartung zu ermöglichen.

Der Antrieb für die Rundkathoden 9 ist im äußeren Teil des Einschubs 8 integriert. Der Einschub 8 für die Flachkathode 9 weist einen nicht dargestellten Hebel auf, mit dem die Flachkathode 9 zum Abmontieren um ca. 180° gedreht werden kann.

Die Außenkonturen des Flansches 11 sind mit dem Bezugszeichen 11' bezeichnet und gestrichelt dargestellt, die Außenkonturen der Einschübe 8 sind mit den Bezugszeichen 8', 8" als durchgezogene Linien eingezeichnet. Blenden 17, die gleichzeitig als Anoden dienen, sowie weitere Abschirmungen schützen die Innenseite der Wände der Beschichtungskammer 2 vor einer Beaufschlagung mit Beschichtungsmaterial. Die gleiche Funktion kommt dem Abschirmblech 8" im Hintergrund des Substrats 3 (bezogen auf die Kathoden 9) zu, wobei auch dieses Abschirmblech 8" ein Teil des Einschubs 8 ist. In einem Bereich der Blende 17 ist eine Kühlung (nicht dargestellt) vorgesehen. Eine weitere Kühlung für die Kathoden 9 ist ebenfalls im Einschub 8 integriert.

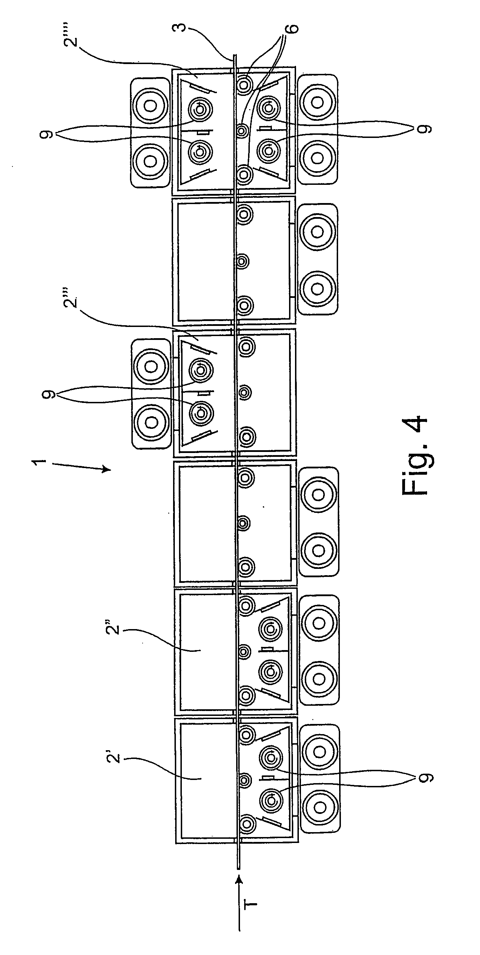

In der Fig. 3 sind lediglich zwei Einschübe 8 dargestellt. In der Regel werden in einer Glasbeschichtungsanlage 1 jedoch eine Reihe hintereinander angeordneter Kammersegmente 2', 2", 2"',... mit entsprechenden Einschüben 8 vorgesehen sein, wie in Fig. 4 gezeigt.

In den Kammersegmenten 2', 2", 2"', ... können gleiche oder unterschiedliche Behandlungs- bzw. Beschichtungsprozesse ablaufen. Die Segmente 2', 2", 2"', ... sind durch Spaltschleusen voneinander abgetrennt, die an den Vorder- und den Rückwänden der Kammersegmente 2', 2", 2"', ... zum Durchführen des Substrats 3 angeordnet sind. Durch die Schleusen werden die Substrate 3 von einem Kammersegment in die nächste transportiert.

Während die Kammersegmente 2', 2" für ein "Sputter-Up"-Verfahren eingerichtet sind, wird in dem Segment 2"' "Sputter-Down" durchgeführt. Im Segment 2"" findet eine simultane Beschichtung der Substratoberseite und der Substratunterseite statt. Der Einschub 8 für dieses Kammersegment 2"" ist daher im wesentlichen symmetrisch zur Transportebene des Substrats 3 ausgeführt, mit jeweils zwei rotierenden Kathoden 9 auf den beiden Seiten des Substrats und spiegelsymmetrischen Blendenanordnungen 17. Einfach ausgeführt sind die insgesamt drei Transportrollen 6 für den Transport des Substrats 3 durch das Segment 2"". Im Fall der zweiseitigen Beschichtung des Substrats 3 sind sowohl am Deckel als auch am Bodenteil des entsprechenden Kammersegments 2"" Pumpen 5 vorgesehen. Die Hochvakuumpumpen (TMPs) sind mit der Anlage 1 verschraubt und können unabhängig von den übrigen Komponenten der Anlage 1 abgenommen werden.

Zwischen den Segmenten 2" und 2"' ist eine Pumpkammer angeordnet, auf die bei der im Zusammenhang mit dieser Erfindung gezeigten Anordnung der Pumpen 5 jedoch in der Regel verzichtet werden kann.

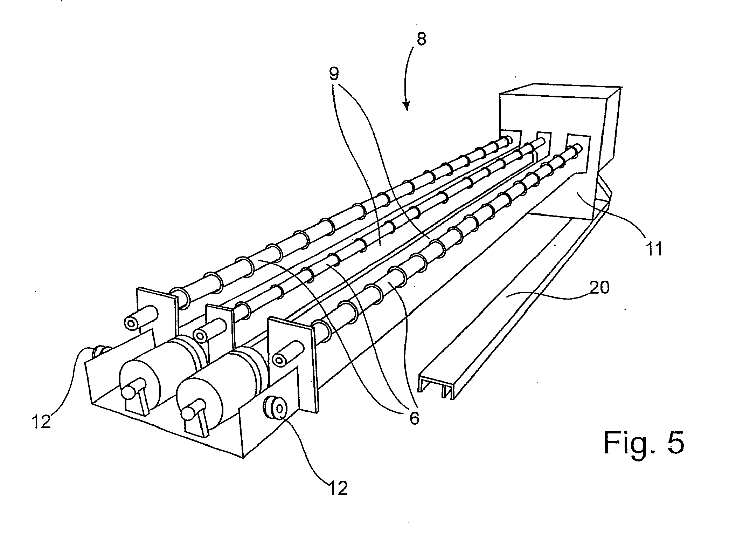

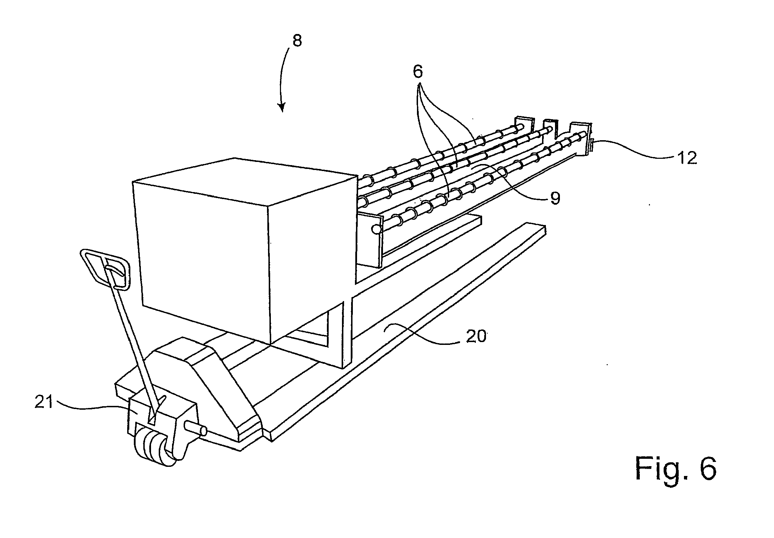

Die Fig. 5 und 6 zeigen perspektivische Ansichten eines erfindungsgemäßen, aus der Beschichtungskammer 2 herausgezogenen Einschubs 8 mit den vorher verwendeten Bezugszeichen für die einzelnen Komponenten.

Ein Basiselement 20 des Einschubs 8 ist in diesem Beispiel so ausgebildet, dass ein Hubwagen 21 eingreifen und der Einschub 8 auf bequeme Weise transportiert werden kann.

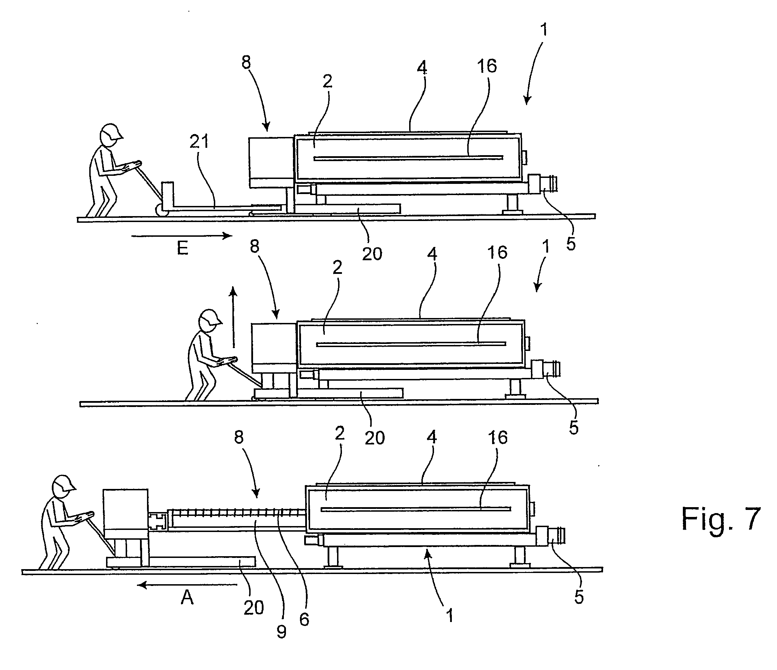

In Fig. 7 ist schematisch ein Einschubwechsel dargestellt. Das Bedienpersonal fährt einen Hubwagen 21 von der Seite an die Anlage 1 heran. Der Hubwagen wird in Einschubrichtung E bewegt und greift in das dafür vorgesehene Basiselement 20 des Einschubs 8 ein. Anschließend wird der Einschub 8 angehoben und in Auszugrichtung A aus der Beschichtungskammer 2 herausgezogen.

Der Einschub 8 kann alternativ auf Rollen, auf einem Luftpolster, auf Schienen, o.ä. bewegt werden.

Die Komponenten des Einschubs 8 können nun an Ort und Stelle bequem zugänglich gewartet oder gegen einen vorbereiteten Ersatzeinschub ausgetauscht werden. Der aus der Kammer 2 entfernte Einschub 8 kann, unter Umständen auf Schienen, abtransportiert werden, während der zweite, neu bestückte und gewartete Einschub 8 von der anderen Seite an die Seitenöffnung 10 der Beschichtungskammer 2 herangefahren und in das leere Kammersegment 2' eingeschoben wird.

Die Einschübe 8 können vollständig aus der Beschichtungskammer 2 herausgefahren werden. Ein Eingriff in die Beschichtungskammer 2 zur Wartung bzw. Säuberung von Einbaukomponenten ist somit nicht mehr notwendig. Auf diese Weise wird die Wartung nicht nur vereinfacht, die Ausfallzeiten der Anlage 1 können auch deutlich reduziert werden. Alle prozessbedingt verschmutzten Teile befinden sich im Einschub 8 bzw. sind ein Teil des Einschubs 8. Außerdem kann die Reinigung und Wartung ohne Zeitdruck vorgenommen werden, wenn die Anlage während der Durchführung der Arbeiten mit einem Ersatz-Einschub 8 wieder in Betrieb geht. Dies führt insgesamt zu einer Zeit- und Kostenersparnis beim Betrieb der Glasbeschichtungsanlage 1.

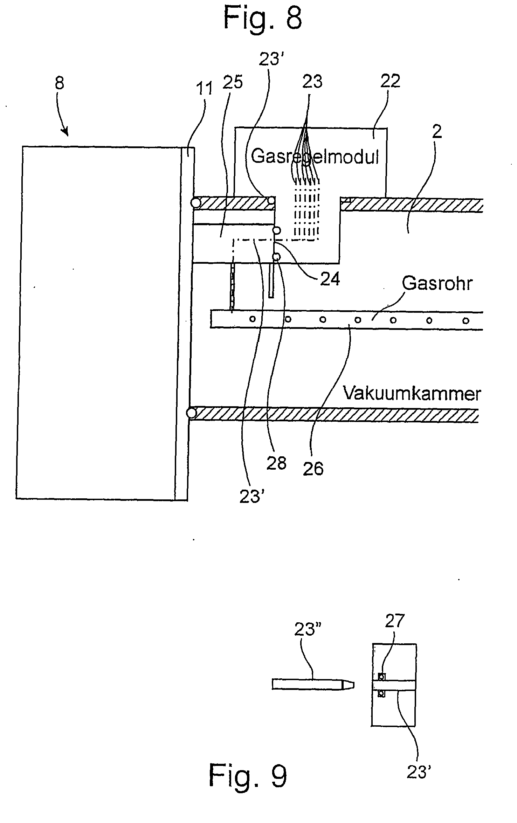

Fig. 8 zeigt eine spezielle Ausführung eines mit der Beschichtungskammer 2 verbundenen Gasregelmoduls 22. Das Gasregelmodul 22 ist an der Beschichtungskammer 2 befestigt und weist mehrere einzelne Gasflussregler auf. Dadurch kann das Einschubelement kostengünstiger gestaltet werden. Gasleitungen 23 führen in den Innenraum der Kammer 2. Die Gasleitungen 23 werden in dem nach unten in die Kammer ragenden Bauteil zu einer einzigen Gasleitung 23' zusammengeführt. Die Gasleitung 23' endet an einer Trennstelle 24, um dort in die Leitung 23" zu münden, die in der Komponente 25 integriert ist. Die Komponente 25 bildet einen Teil des Einschubs 8, ist also zusammen mit diesem aus der Kammer 2 herausziehbar. Die Gasleitung 23" mündet in ein Gasrohr 26. Im Gasrohr 26 sind Öffnungen (kreisförmig dargestellt) angeordnet, durch die das über das Gasregelmodul 22 zugeführte Prozessgas in die Vakuumkammer gelangt. Die Verbindung zwischen den Leitungen 23' und 23" an der Trennstelle 24 erfolgt beispielsweise durch das Einführen eines Rohres (Gasleitung 23") in eine Bohrung (welches die Gasleitung 23' bildet), wie in der Detailskizze Fig. 9 gezeigt.

Das Rohr 23' kann gegenüber der Bohrung 23' mit einem oder mehreren Dichtringen 27 abgedichtet sein. Ebenso kann zur Abdichtung des Übergangs an der Trennstelle 24 ein Dichtring 28 angeordnet sein, um den einschubseitigen Teil vom kammerseitigen Teil zu trennen.

Die Trennung 24 der Gasverbindung(en) wird auf diese Weise in die Vakuumkammer verlegt, so dass eventuelle Undichtigkeiten an der Trennstelle der Gasleitung nicht nach außen hin wirksam werden können. Der Anschlussbereich 24 befmdet sich innerhalb der Prozesskammer 2 unter Prozesskammerdruck, wogegen die Gaszuführungsleitungen von der Gasversorgung bis zum Gasflussregler einen Druck von ca. 3 bar aufweisen.

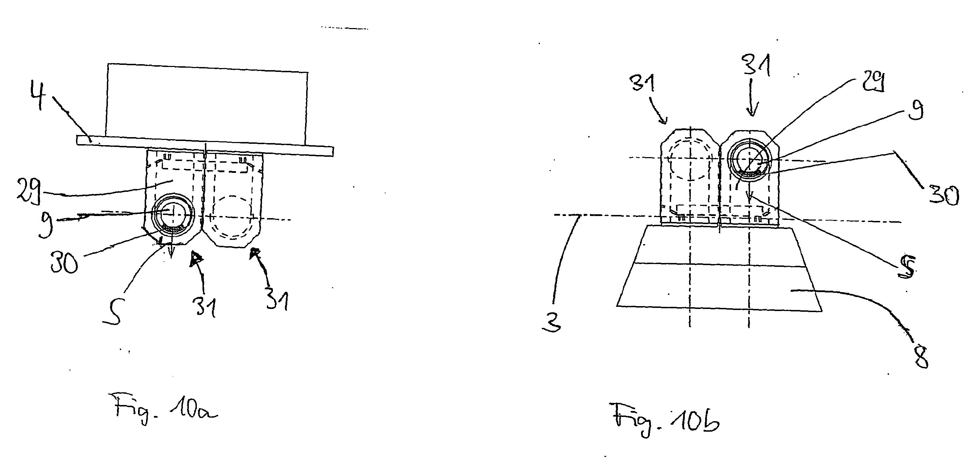

In den Figuren 10a und 10b ist eine spezielle Ausführungsform der Beschichtungswerkzeuge 9 dargestellt. Dabei bilden Rohrkathoden bzw. Rohrtargets zusammen mit jeweils zwei Halterungsblöcken 29, an deren Enden die Rohrkathoden befestigt sind, eine Kathodeneinheit 31. In den Figuren sind jeweils zwei Kathodeneinheiten 31 nebeneinander dargestellt.

In Fig. 10a ist dabei ein aus dem Stand der Technik bekannter Fall gezeigt, bei dem die Kathodeneinheiten 31 an einem Deckelflansch 4, beispielsweise an einem Kammerdeckel hängend, befestigt sind. Die Kathoden, die als Magnetronkathoden ausgebildet sind, weisen eine Magnetleiste 30, die zur Erzeugung des in Richtung eines Substrats 3 ausgerichteten Magnetfelds vorgesehen ist, auf. Die Magnetleiste 30 ist innerhalb des Rohrtargets im unteren Bereich desselben angeordnet und zum Substrat 3 hin, also in Richtung nach unten, ausgerichtet. Die Sputterrichtung S erstreckt sich dementsprechend nach unten zum Substrat 3 hin.

Für den Einsatz solcher kommerziell erhältlicher Kathodeneinheiten ist daher, wie in der Fig. 10b dargestellt, eine erfindungsgemäßen Anordnung der Kathodeneinheiten 31 an dem Einschubelement 8 notwendig. Die Halterungsblöcke 29 sind dabei aufrecht stehend am Einschubelement 8 lösbar befestigt. Im Beschichtungsbetrieb bewegen sich die Substrate 3 zwischen den beiden Halterungsblöcken 29 unter dem Kathodenrohr hindurch. Die Magnetleiste 30 wird bereits beim Einbau in die Rohrkathode nach unten in Sputterrichtung S und in Richtung des zwischen den Halterungsblöcken 29 unterhalb der Kathode 9 durchgeführten Substrats 3 ausgerichtet. Zum Abnehmen des Targets kann das Einschubelement 8 aus der Beschichtungskammer 2 herausgezogen und das Target vom Einschubelement 8 abgenommen werden. Durch die Gesamtanordnung wird sowohl der Einbau als auch der Ausbau des Magnetsystems aus der Kathode erleichtert.

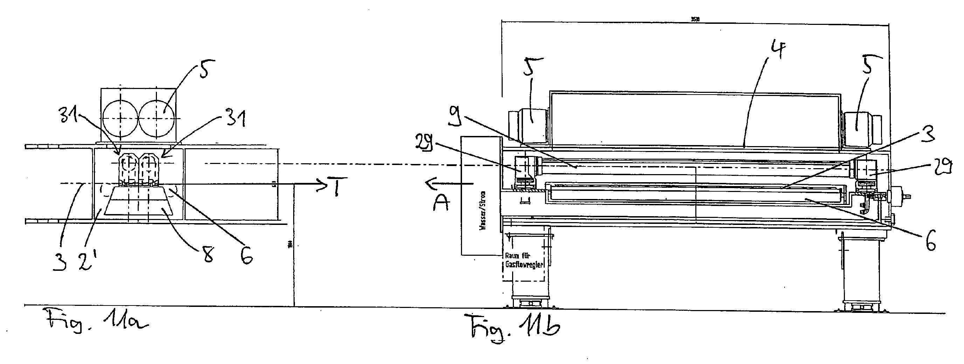

Eine entsprechende Konfiguration, in der die Kathodeneinheit 31 an einem erfindungsgemäßen Einschubelement 8 angeordnet ist, ist in der Fig. 11 a dargestellt. Mit T ist die Transportrichtung und Transportebene des Substrats angegeben. Oberhalb der Beschichtungskammer 2 befindet sich, wie auch in der Fig. 11b gezeigt, im Kammerdeckel 4 ein Saugraum mit seitlich daran angeordneten Turbomolekularpumpen 5. Vorteilhafterweise bewegt sich das Substrat 3 auf Transportrollen 6 unterhalb der Kathode 9 durch das Kammersegment. Bei dieser Ausführungsform ist es notwendig, wie bereits im Zusammenhang mit der Fig. 10b beschrieben, die Magnetleiste im Magnetrohr bereits beim Einbau und beim Ausbau im unteren Teil der Rohrkathode 9 anzuordnen.

Wie aus der Fig. 11b deutlich wird, können Medienanschlüsse durch die Halterungsblöcke 29, die die Enden der Kathode 9 tragen, nach unten hindurchgeführt werden. Die Zufuhrleitungen für die benötigten Medien können auf diese Weise unterhalb des Substrats verlaufen.

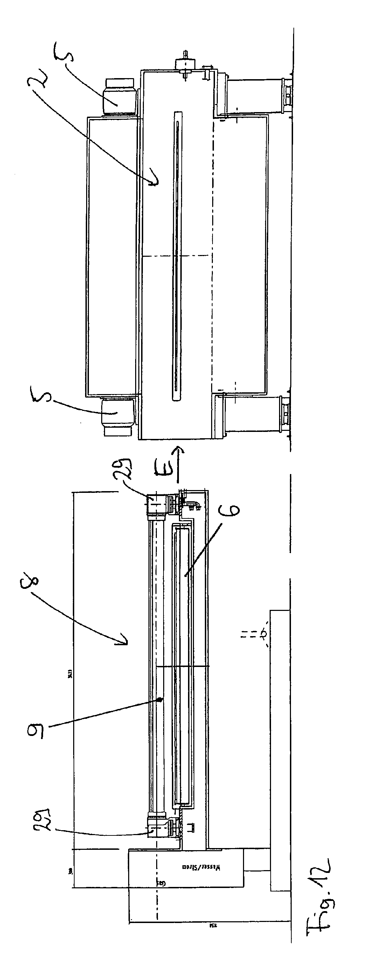

Die Fig. 12 zeigt eine Beschichtungskammer 2 und daneben ein aus der Beschichtungskammer 2 herausgezogenes Einschubelement 8 (Einschubrichtung E) mit Transportrollen 6, einer Rohrkathode 9, und an den Enden der Rohrkathode 9 angeordneten Halterungsblöcken 29, die zusammen mit der Kathode 9 eine Kathodeneinheit 31 bilden. Die Halterungsblöcke sind abnehmbar stehend auf dem Einschubelement 8 befestigt. Ein Substrat wird im Betrieb zwischen den Halterungsblöcken 29 unterhalb der Kathode hindurch transportiert. Die Kathodeneinheit umfasst ferner Medienanschlüsse an der Unterseite der Halterungsblöcke 29.

### Bezugszeichenliste

1 Glasbeschichtungsanlage
2 Beschichtungskammer
2', 2", 2'" ,... Kammersegmente
2a, 2b Seitenwände der Beschichtungskammer
2c, 2d Flansche
3 Substrat
4 Kammerdeckel
5 Pumpen (TMP)
6 Transportrollen
7 obere Öffnung der Kammer
8 Einschub
8' Außenkontur des Einschubs 8
8" Rückwand des Einschubs 8
9 Kathode
10 seitliche Öffnung in der Kammerwand
11 Flansch
11' Außenkontur des Flansches 11
12 Rolle
13 Führung
14 Kupplung
15 Antriebselement
16 Schleuse
17 Blende, Anode
18 Abschirmung
19 Kühlung
20 Basiselement
21 Hubwagen
22 Gasregelmodul
23, 23', 23" Gasleitungen
24 Trennstelle
25 Komponente des Einschubs 8
26 Gasrohr
27 Dichtring
28 Dichtring
29 Halterungsblock
30 Magnetleiste
31 Kathodeneinheit
E Einschubrichtung
A Auszugsrichtung
T Transportrichtung für das Substrat
S Sputterrichtung

## Patentansprüche

1. Anlage (1) zum Beschichten eines Substrats (3), insbesondere eines transparenten Substrats (3), insbesondere zur Herstellung von Architekturglas, umfassend wenigstens eine Beschichtungskammer (2), **gekennzeichnet durch** wenigstens ein Einschubelement (8), das Beschichtungswerkzeuge (9) zum Aufbringen einer Beschichtung auf das Substrat (3) aufweist, die am Einschubelement (8) angeordnet und zusammen mit dem Einschubelement (8) in den Innenraum der Beschichtungskammer (2) einschiebbar bzw. aus diesem herausziehbar sind.

2. Anlage (1) nach Anspruch 1, **dadurch gekennzeichnet, dass** wenigstens eine Öffnung (10) an einer Seitenwand der Beschichtungskammer (2) derart ausgebildet ist, dass das Einschubelement (8) in die Beschichtungskammer (2) einschiebbar ist.

3. Anlage (1) nach Anspruch 2, **dadurch gekennzeichnet, dass** die Beschichtungskammer (2) und das Einschubelement (8) derart aneinander angepasst sind, dass das Einschubelement (8) schubladenartig in die Öffnung (10) der Beschichtungskammer (2) einschiebbar ist.

4. Anlage (1) nach einem der Ansprüche 1 bis 3, **dadurch gekennzeichnet, dass** die Anlage (1) wenigstens eine Pumpeinrichtung (5) zur Erzeugung eines Vakuums in der Beschichtungskammer (2) aufweist.

5. Anlage (1) nach Anspruch 4, **dadurch gekennzeichnet, dass** das Einschubelement (8) unabhängig von der Pumpeinrichtung (5) gegenüber der Beschichtungskammer (2) bewegbar angeordnet ist.

6. Anlage (1) nach einem der Ansprüche 1 bis 5, **dadurch gekennzeichnet, dass** die Anlage (1) so ausgebildet ist, dass ein flächiges Substrat im wesentlichen horizontal durch die Beschichtungskammer (2) transportiert wird.

7. Anlage (1) nach einem der Ansprüche 1 bis 6, **dadurch gekennzeichnet, dass** die Kathoden (9) horizontal ausgerichtet sind.

8. Anlage (1) nach einem der Ansprüche 1 bis 7, **dadurch gekennzeichnet, dass** das Einschubelement (8) einen Anschluss für die Spannungsversorgung des Einschubelements (8) umfasst, der so ausgebildet ist, dass er beim Einschub des Einschubelements (8) in die Beschichtungskammer (2) mit einem an der Anlage (1) angeordneten entsprechenden Anschluss in Eingriff kommt, um die Versorgungsverbindung herzustellen.

9. Anlage (1) nach einem der Ansprüche 1 bis 8, **dadurch gekennzeichnet, dass** die Beschichtungskammer (2) in ihrem Innenraum mindestens eine Kupplung (15) aufweist, um mit Transportrollen des Einschubelements (8) zu koppeln.

10. Anlage (1) nach einem der Ansprüche 1 bis 9, **dadurch gekennzeichnet, dass** die Beschichtungskammer (2) in ihrem Innenraum mindestens eine Kupplung aufweist, um mit den drehbaren Kathoden zu koppeln und diese bei geschlossener Anlage anzutreiben.

11. Anlage (1) nach einem der Ansprüche 1 bis 10, **dadurch gekennzeichnet, dass** die Anlage (1) ein Gasregelmodul (22) aufweist, das mit der Beschichtungskammer (2) verbunden ist, wobei das Gasregelmodul (22) wenigstens einen Gasanschluss zum Kammerinneren aufweist, und das Einschubelement (8) entsprechende Gasanschlüsse und Gasleitungen (23") aufweist, durch die vom Gasregelmodul (22) zugeführtes Prozessgas durch den Innenraum der Kammer (2) geleitet und über die das Prozessgas in die Kammer (2) eingebracht wird.

12. Einschubelement (8) für eine Anlage (1) zum Beschichten eines Substrats (3), insbesondere eines transparenten Substrats, **dadurch gekennzeichnet, dass** das Einschubelement (8) Beschichtungswerkzeuge (9) zum Aufbringen einer Beschichtung auf das Substrat (3) aufweist, die am Einschubelement angeordnet und zusammen mit dem Einschubelement (8) in den Innenraum einer Beschichtungskammer (2) einschiebbar bzw. aus diesem herausziehbar sind.

13. Einschubelement (8) nach Anspruch 12, **dadurch gekennzeichnet, dass** das Einschubelement (8) schubladenartig in den Innenraum der Beschichtungskammer (2) einschiebbar bzw. aus diesem herausziehbar ist.

14. Einschubelement (8) nach Anspruch 12 oder 13, **dadurch gekennzeichnet, dass** im Einschubelement (8) weitere Komponenten einer Beschichtungsanlage integriert sind, die einem prozessbedingten Verschleiß, einer prozessbedingten Verschmutzung und/oder Beaufschlagung mit Beschichtungsmaterial unterliegen.

15. Einschubelement (8) nach einem der vorhergehenden Ansprüche 12 bis 14, **dadurch gekennzeichnet, dass** das Einschubelement (8) Blenden (17) und/oder Abschirmungen (18) aufweist.

16. Einschubelement (8) nach einem der vorhergehenden Ansprüche 12 bis 15, **dadurch gekennzeichnet, dass** das Beschichtungswerkzeug (9) wenigstens eine Kathode umfasst.

17. Einschubelement (8) nach Anspruch 16, **dadurch gekennzeichnet, dass** das Beschichtungswerkzeug (9) eine Kathodeneinheit (31) mit wenigstens zwei Halterungen (29) zum Halten der Kathode, insbesondere eines Rohrtargets, umfasst.

18. Einschubelement (8) nach Anspruch 17, **dadurch gekennzeichnet, dass** die Halterungen (29) stehend auf dem Einschubelement angeordnet sind.

19. Einschubelement (8) nach Anspruch 17, **dadurch gekennzeichnet, dass** die Halterungen (29) parallel zur Achse des Rohrtargets angeordnet sind.

20. Einschubelement (8) nach einem der vorhergehenden Ansprüche 12 bis 19, **dadurch gekennzeichnet, dass** das Beschichtungswerkzeug (9) wenigstens eine Flachkathode umfasst.

21. Einschubelement (8) nach Anspruch 20, **dadurch gekennzeichnet, dass** das Einschubelement (8) eine Vorrichtung zum Drehen der Kathode (9) in eine Position zum Zugriff für Wartungszwecke und/oder für einen Targetwechsel aufweist.

22. Einschubelement (8) nach einem der vorhergehenden Ansprüche 12 bis 21, **dadurch gekennzeichnet, dass** das Beschichtungswerkzeug (9) wenigstens eine rotierbare Kathode umfasst.

23. Einschubelement (8) nach Anspruch 22, **dadurch gekennzeichnet, dass** das Einschubelement (8) eine Antriebseinheit oder eine Kupplung für eine Antriebseinheit zur Rotation der Kathode aufweist.

24. Einschubelement (8) nach einem der vorhergehenden Ansprüche 12 bis 23, **dadurch gekennzeichnet, dass** das Einschubelement (8) wenigstens eine Anode (17) aufweist.

25. Einschubelement (8) nach einem der vorhergehenden Ansprüche 12 bis 24, **dadurch gekennzeichnet, dass** das Einschubelement (8) eine Transporteinrichtung (6) zum vorzugsweise kontinuierlichen Transport des Substrats aufweist.

26. Einschubelement (8) nach Anspruch 25, **dadurch gekennzeichnet, dass** die Transporteinrichtung (6) Transportrollen umfasst, durch die das Substrat bewegt wird.

27. Einschubelement (8) nach einem der vorhergehenden Ansprüche 12 bis 26, **dadurch gekennzeichnet, dass** das Einschubelement (8) eine Vorrichtung zur Kühlung der Blenden, Abschirmungen (17) und/oder der Beschichtungswerkzeuge (9) aufweist.

28. Einschubelement (8) nach einem der vorhergehenden Ansprüche 12 bis 27, **dadurch gekennzeichnet, dass** das Einschubelement (8) einen Flansch (11) zum Verschluss einer für den Einschub des Einschubelements (8) vorgesehenen Öffnung (10) in der Beschichtungskammer (2) aufweist.

29. Einschubelement (8) nach einem der vorhergehenden Ansprüche 12 bis 28, **dadurch gekennzeichnet, dass** das Einschubelement (8) verfahrbar oder verschiebbar ausgebildet ist.

30. Einschubelement (8) nach einem der vorhergehenden Ansprüche 12 bis 29, **dadurch gekennzeichnet, dass** das Einschubelement (8) Versorgungseinrichtungen für die Medienversorgung aufweist.

31. Einschubelement (8) nach einem der vorhergehenden Ansprüche 12 bis 30, **dadurch gekennzeichnet, dass** das Einschubelement (8) Anschlüsse für die Medienversorgung aufweist.

32. Einschubelement (8) nach einem der vorhergehenden Ansprüche 12 bis 31, **dadurch gekennzeichnet, dass** das Einschubelement (8) Regler für die Regelung der Zufuhr von Prozessgas aufweist.

33. Einschubelement (8) nach einem der vorhergehenden Ansprüche 12 bis 32, **dadurch gekennzeichnet, dass** das Einschubelement (8) derart ausgebildet ist, dass beidseitig des Transportwegs des Substrats (3) Beschichtungswerkzeuge (9) zur beidseitigen Beschichtung des Substrats (3) angeordnet sind.

34. Einschubelement nach einem der Ansprüche 26 bis 33, **dadurch gekennzeichnet, dass** die Transportrollen derart angeordnet sind, dass die den Rollen zugewandte Seite eines Substrats (3) durch rollenseitig angeordnete Beschichtungswerkzeuge (9) beschichtet werden kann.

35. Einschubelement (8) nach Anspruch 34, **dadurch gekennzeichnet, dass** die Transportrollen eine Abschirmung (18) derart aufweisen, dass die Verschmutzung der Rollen durch unmittelbar von den Beschichtungswerkzeugen (9) abgesputtertes Material verhindert wird.

36. Einschubelement (8) nach Anspruch 35, **dadurch gekennzeichnet, dass** die Abschirmung (18) für die Transportrollen über die ganze Beschichtungsbreite der Substrate reicht und mehrere Transportrollen abdeckt.
